(19)

Europäisches
Patentamt

European
Patent Office

Office européen
des brevets

(11) **EP 3 492 624 A1**

(12) **EUROPEAN PATENT APPLICATION**
published in accordance with Art. 153(4) EPC

(43) Date of publication:
**05.06.2019 Bulletin 2019/23**

(21) Application number: **17834113.7**

(22) Date of filing: **19.07.2017**

(51) Int Cl.:
*C23C 14/34* (2006.01)      *B22F 1/00* (2006.01)
*C22C 1/04* (2006.01)      *C22C 9/00* (2006.01)
*C22C 28/00* (2006.01)      *C22C 30/02* (2006.01)
*H01L 31/0749* (2012.01)      *H01L 31/18* (2006.01)

(86) International application number:
**PCT/JP2017/026073**

(87) International publication number:
**WO 2018/021105 (01.02.2018 Gazette 2018/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **29.07.2016  JP 2016149404
15.03.2017  JP 2017050548**

(71) Applicant: **Mitsubishi Materials Corporation
Chiyoda-ku
Tokyo 100-8117 (JP)**

(72) Inventors:
• **UMEMOTO Keita**
  **Sanda-shi**
  **Hyogo 669-1339 (JP)**
• **IO Kensuke**
  **Sanda-shi**
  **Hyogo 669-1339 (JP)**
• **ZHANG Shoubin**
  **Sanda-shi**
  **Hyogo 669-1339 (JP)**
• **SHIONO Ichiro**
  **Sanda-shi**
  **Hyogo 669-1339 (JP)**

(74) Representative: **Hoffmann Eitle
Patent- und Rechtsanwälte PartmbB
Arabellastraße 30
81925 München (DE)**

(54) **Cu-Ga SPUTTERING TARGET AND METHOD FOR PRODUCING Cu-Ga SPUTTERING TARGET**

(57)     A Cu-Ga sputtering target of the present invention includes, as a composition of metal components, Ga in a range of 5 at% to 60 at%, at least one additive element selected from the group consisting of K, Rb, and Cs in a range of 0.01 at% to 5 at%, and a balance including Cu and inevitable impurities, in which all or a part of the additive element is present in a state of halide particles including at least one halogen selected from the group consisting of F, Cl, Br, and I, a maximum particle size of the halide particles is 15 $\mu$m or less, and an oxygen concentration is 1000 mass ppm or less.

FIG. 1

5.0 $\mu$m

EP 3 492 624 A1

## Description

TECHNICAL FIELD

The present invention relates to a Cu-Ga sputtering target used for forming a Cu-In-Ga-Se quaternary alloy thin film that forms, for example, a light-absorbing layer of a CIGS solar cell, and a method of manufacturing the Cu-Ga sputtering target.

Priority is claimed on Japanese Patent Application No. 2016-149404, filed on July 29, 2016 and Japanese Patent Application No. 2017-050548, filed on March 15, 2017, the contents of which are incorporated herein by reference.

BACKGROUND ART

In the related art, as a thin film solar cell formed of a compound semiconductor, a CIGS solar cell that includes a light-absorbing layer formed of a Cu-In-Ga-Se quaternary alloy thin film is provided.

Here, as a method of forming the light-absorbing layer formed of a Cu-In-Ga-Se quaternary alloy thin film, a method of forming the light-absorbing layer using a vapor deposition method is known. A solar cell that includes a light-absorbing layer formed using a vapor deposition method has an advantageous effect in that the energy conversion efficiency is high, but has a problem in that it is not suitable for an increase in area and the production efficiency is low.

Therefore, a method of forming a light-absorbing layer formed of a Cu-In-Ga-Se quaternary alloy thin film using a sputtering method is disclosed.

In the sputtering method, first, an In film is formed using an In sputtering target, and then a Cu-Ga film is formed on the In film using a Cu-Ga sputtering target. As a result, a multilayer film including the In film and the Cu-Ga film is formed. By performing a heat treatment on the multilayer film in a Se atmosphere to selenize the multilayer film, a Cu-In-Ga-Se quaternary alloy thin film is formed.

Here, regarding the Cu-In-Ga-Se quaternary alloy thin film that forms the light-absorbing layer, it is known that the conversion efficiency of a solar cell is improved by adding an alkali metal such as Na or K.

Therefore, as a method of adding an alkali metal to a Cu-In-Ga-Se quaternary alloy thin film, for example, Patent Document 1 discloses a method of adding an alkali metal to a Cu-Ga sputtering target used for forming a Cu-Ga film.

Alkali metals are highly reactive and unstable in the form of a single substance. Therefore, in the Cu-Ga sputtering target described in Patent Document 1, an alkali metal is added as an alkali metal compound. Specifically, in Patent Document 1, $Li_2O$, $Na_2O$, $K_2O$, $Li_2S$, $Na_2S$, $K_2S$, $Li_2Se$, $Na_2Se$, or $K_2Se$ is added. In particular, it is preferable to add a Se compound. In addition, Patent Document 2 discloses that the alkali metal is added in a state of NaF.

Citation List

Patent Literature

[Patent Document 1] Republished Japanese Translation No. WO2011/083647 of the PCT International Publication for Patent Applications
[Patent Document 2] Japanese Patent No. 4793504

DISCLOSURE OF INVENTION

Technical Problem

However, recently, further improvement of the conversion efficiency of a solar cell has been required, and it is necessary to add a higher concentration of an alkali metal than in the related art to a Cu-In-Ga-Se quaternary alloy thin film that forms a light-absorbing layer. That is, in the Cu-Ga sputtering targets described in Patent Documents 1 and 2, there were concerns that the content of the alkali metal was low and improvement of the conversion efficiency was insufficient.

Therefore, a configuration of adding a larger amount of an alkali metal compound than in the related art to a Cu-Ga sputtering target is considered. However, the alkali metal compound is basically an insulator, and thus there was a concern that, in a case of simply increasing an addition amount, the alkali metal compound may cause abnormal discharge. In particular, alkali metal halides having an atomic number larger than Na such as KF, KCl, RbF, RbCl, CsF, and CsCl are likely to absorb moisture, and the halides that have absorbed moisture are likely to form aggregated particles. Therefore, in a case of increasing the addition amount of halides of K, Rb, and Cs, comparatively large insulators (halide particles of K, Rb, and Cs) are likely to be formed in the Cu-Ga sputtering target, and thus there was a concern that abnormal discharge was likely to occur.

The present invention has been made in view of the above described circumstances, and an object of the present invention is to provide a Cu-Ga sputtering target capable of stably forming a Cu-Ga film that includes a relatively large amount of halides of K, Rb, and Cs, which are alkali metal compounds, and has a composition in which K, Rb, and Cs are uniformly dispersed, and a method of manufacturing the Cu-Ga sputtering target.

Solution to Problem

According to the present invention, in order to solve the problems, there is provided a Cu-Ga sputtering target including: as a composition of metal components, Ga in a range of 5 at% to 60 at%; at least one additive element selected from the group consisting of K, Rb, and Cs in a range of 0.01 at% to 5 at%; and a balance including Cu and inevitable impurities, in which all or a part of the additive element is present in a state of halide particles including at least one halogen selected from the group consisting of F, Cl, Br, and I, a maximum particle size of the halide particles is 15 $\mu$m or less, and an oxygen concentration is 1000 mass ppm or less.

According to the Cu-Ga sputtering target of the present invention having the above-described configuration, the Cu-Ga sputtering target has a composition including Ga in a range of 5 at% to 60 at%, at least one additive element selected from the group consisting of K, Rb, and Cs in a range of 0.01 at% to 5 at%, and a balance including Cu and inevitable impurities. Therefore, a Cu-Ga film having a relatively large amount of K, Rb, and Cs which are alkali metals can be formed.

K, Rb, and Cs which are additive elements are included as halide particles of which the maximum particle size is 15 $\mu$m or less. Therefore, abnormal discharge during sputtering can be suppressed and a Cu-Ga film in which K, Rb, and Cs are uniformly dispersed can be stably formed.

Further, the oxygen concentration is 1000 mass ppm or less. Therefore, there is less of oxides having high electric resistance and the abnormal discharge during sputtering can be more reliably suppressed.

Here, in the Cu-Ga sputtering target of the present invention, it is preferable that variation of a content of the additive element be 0.05 mass% or less.

In this case, the variation of the content of K, Rb, and Cs which are additive elements is as small as 0.05% or less. Therefore, the Cu-Ga film in which K, Rb, and Cs are uniformly dispersed can be reliably formed.

In addition, the Cu-Ga sputtering target of the present invention may further include Na in a range of 0.01 at% to 10 at%, and Na may be present in a state of Na compound particles including at least one element selected from the group consisting of F, Cl, Br, I, S, and Se.

In this case, the Cu-Ga film in which Na which is an alkali metal is uniformly dispersed together with K, Rb, and Cs can be stably formed.

According to the present invention, there is provided a method of manufacturing the above-described Cu-Ga sputtering target, the method including: a Cu-halide mixed powder preparing step of crushing and mixing a halide powder including at least one halogen selected from the group consisting of F, Cl, Br, and 1 and at least one additive element selected from the group consisting of K, Rb, and Cs and having an average particle size of 15 $\mu$m or more and a Cu powder having an average particle size smaller than that of the halide powder and a specific surface area of 0.15 m$^2$/g or more at a mixing ratio at which a content of the halide powder is 10 mass% or less to prepare a Cu-halide mixed powder in which a maximum particle size of the halide powder is 15 $\mu$m or less; a mixing step of mixing the Cu-halide mixed powder and Cu-Ga alloy powder to obtain a raw material mixed powder; a filling step of filling a die with the raw material mixed powder; and a sintering step of sintering the raw material mixed powder with which the die was filled to obtain a sintered body, in which the Cu-halide mixed powder preparing step and the mixing step are performed under a gas atmosphere having a dew point of -20°C or lower and higher than -50°C.

In the method of manufacturing the Cu-Ga sputtering target of the present invention having the above-described configuration, in the Cu-halide mixed powder preparing step, a fine powder of which the average particle size is smaller than that of the halide powder and the specific surface area is 0.15 m$^2$/g or more is used as the Cu powder and the mixing ratio between the halide powder and the Cu powder is set such that the content of the halide powder is 10 mass% or less. Therefore, a Cu-halide mixed powder in which the halide powder crushed until the maximum particle size is a size of 15 $\mu$m or less is uniformly dispersed can be obtained. In addition, the Cu-halide mixed powder preparing step and the mixing step are performed under the gas atmosphere having a dew point of -20°C or lower and higher than -50°C. As a result, it is difficult for the halide powder to absorb moisture or for the halide powder that has absorbed moisture to aggregate, and oxygen contamination can be suppressed. Therefore, according to the method of manufacturing the Cu-Ga sputtering target of the present invention, as described above, the abnormal discharge during sputtering can be reduced, and it is possible to obtain a Cu-Ga sputtering target capable of stably forming the Cu-Ga film in which K, Rb, and Cs which are alkali metals are uniformly dispersed.

Advantageous Effects of Invention

According to the present invention, it is possible to provide a Cu-Ga sputtering target capable of stably forming a Cu-Ga film that includes a relatively large amount of halides of K, Rb, and Cs, which are alkali metal compounds, and has a composition in which K, Rb, and Cs are uniformly dispersed, and a method of manufacturing the Cu-Ga sputtering target.

BRIEF DESCRIPTION OF DRAWINGS

FIG. 1 is a scanning electron micrograph of a sputtering surface in a Cu-Ga sputtering target according to an embodiment of the present invention.
FIG. 2 is a flowchart showing a method of manufacturing the Cu-Ga sputtering target according to an embodiment of the present invention.

BEST MODE FOR CARRYING OUT THE INVENTION

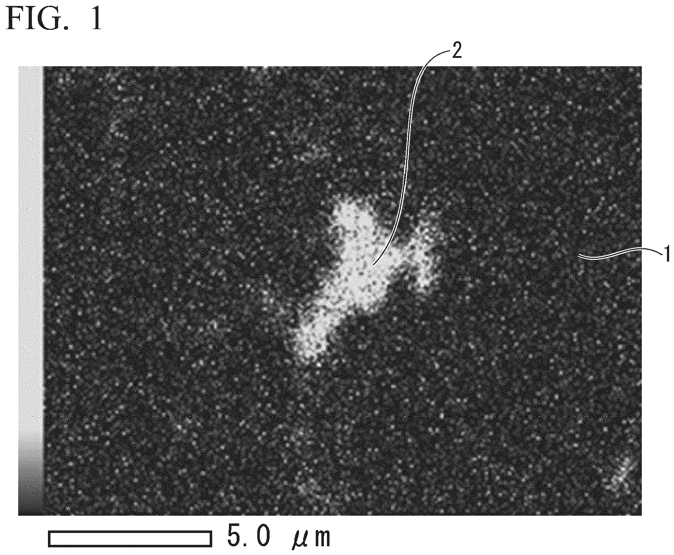

Hereinafter, a Cu-Ga sputtering target according to an embodiment of the present invention, and a method of manufacturing the Cu-Ga sputtering target will be described with reference to the accompanying drawings.
The sputtering target according to the embodiment is used when a Cu-Ga film is formed by sputtering in order to form, for example, a light-absorbing layer formed of a Cu-In-Ga-Se quaternary alloy thin film in a CIGS thin film solar cell.
The Cu-Ga sputtering target according to the embodiment is obtained by adding a halide including at least one additive element selected from the group consisting of K, Rb, and Cs and at least one halogen selected from the group consisting of F, Cl, Br, and I to a Cu-Ga alloy. The Cu-Ga sputtering target has a composition including Ga in a range of 5 at% to 60 at%, an additive element in a range of 0.01 at% to 5 at%, and a balance including Cu and inevitable impurities.
Here, the additive element (K, Rb, and Cs) which is an alkali metal is included in a Cu-Ga film formed of the Cu-Ga sputtering target and has an effect of improving a conversion efficiency of a CIGS thin film solar cell. In the embodiment, the additive element is included in a relatively large amount of 0.01 at% to 5 at%.
In the Cu-Ga sputtering target according to the embodiment, the additive element is included as halide particles. That is, as shown in FIG. 1, the Cu-Ga sputtering target has a structure in which halide particles 2 are dispersed in a Cu-Ga parent phase 1.
The halide particles 2 have a maximum particle size of 15 $\mu$m or less. Here, the maximum particle size means the largest value among particle sizes of the halide particles 2 in an observation range of 50 mm $\times$ 50 mm randomly selected in a surface of the Cu-Ga sputtering target. The particle size of each of the halide particles 2 is a circumscribed circle equivalent diameter, that is, a diameter of a circle circumscribing an area of the halide particles 2 observed by a scanning electron microscope (SEM).
When the halide particles 2 are present in the sputtering surface of the Cu-Ga sputtering target as particles having particle sizes greater than 15 $\mu$m, abnormal discharge frequently occurs during DC sputtering, and thus it is difficult to form the Cu-Ga film stably and reliably. Therefore, in the embodiment, the maximum particle size of the halide particles 2 is set to 15 $\mu$m or less. The maximum particle size of the halide particles 2 is preferably 10 $\mu$m or less and particularly preferably 8 $\mu$m or less. A lower limit of the maximum particle size of the halide particles 2 is not particularly limited, but preferably 0.1 $\mu$m.
In addition, in Cu-Ga sputtering target according to the embodiment, the variation of the contents of K, Rb, and Cs which are the additive elements is 0.05% or less. Here, the variation of the contents of the additive elements is a value obtained as follows.
First, sample pieces are taken out of 45 positions of the Cu-Ga sputtering target. For example, the sample pieces can be taken out as follows. The Cu-Ga sputtering target is divided into three equal parts in a longitudinal direction and divided into five equal parts in a lateral direction in the sputtering surface to be divided into 15 blocks in total. Next, the obtained blocks are further divided into five equal parts in a thickness direction to obtain thin blocks. A total of 45 thin blocks of three portions of the top, bottom, and middle portions of the thin blocks divided into five equal parts are taken out as sample pieces.
Next, the contents of the additive elements included in a total of 45 sample pieces that have been taken out are each measured. An average value of measured contents of respective additive elements is calculated, and a value (upper part) obtained by subtracting the average value of the contents of the respective additive elements from the maximum value of measured contents of the respective additive elements and a value (lower part) obtained by subtracting the minimum value of measured contents of the respective additive elements from the average value of the contents of the respective additive elements are obtained as the variation. A unit of the content of the additive element is mass% based on the mass of the sample piece.

When the variation of the contents of the respective additive elements exceeds 0.05 mass%, there is a concern that it will be difficult to form a Cu-Ga film in which the additive element is uniformly dispersed. Therefore, in the embodiment, the variation of the contents of K, Rb, and Cs which are the additive elements is set to 0.05 mass% or less. The lower limit of the variation of the contents of K, Rb, and Cs is not particularly limited, but is preferably 0.001 mass%.

Further, in the Cu-Ga sputtering target according to the embodiment, Na may be included in a range of 0.01 at% to 10 at%. Na may be present in a state of Na compound particles including at least one element selected from the group consisting of F, Cl, Br, I, S, and Se. One kind of the Na compound particles may be used alone and two or more kinds thereof may be used in combination. The maximum particle size of the Na compound particles is preferably 15 μm or less, more preferably 10 μm or less, and particularly preferably 8 μm or less. When the maximum particle size of the Na compound particles becomes too large, abnormal discharge frequently occurs during sputtering, and thus it is difficult to form the Cu-Ga film stably and reliably. The lower limit of the maximum particle size of the Na compound particles is not particularly limited, but is preferably 0.1 μm.

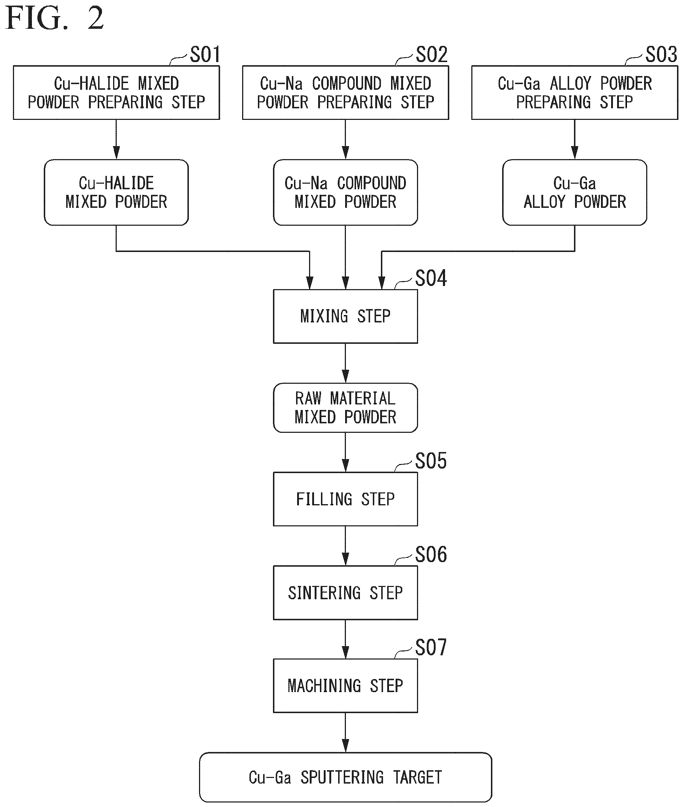

Next, the method of manufacturing the Cu-Ga sputtering target according to the embodiment will be described with reference to a flowchart of FIG. 2.

As shown in FIG. 2, the method of manufacturing the Cu-Ga sputtering target according to the embodiment includes a Cu-halide mixed powder preparing step S01, a Cu-Na compound mixed powder preparing step S02, a Cu-Ga alloy powder preparing step S03, a mixing step S04, a filling step S05, a sintering step S06, and a machining step S07.

<Cu-halide mixed powder preparing step S01>

In the Cu-halide mixed powder preparing step S01, the halide powders and the Cu powders are crushed and mixed to prepare a Cu-halide mixed powder of which the maximum particle size of the halide powder is 15 μm or less.

The halide powder includes at least one halogen selected from the group consisting of F, Cl, Br, and I and at least one additive element selected from the group consisting of K, Rb, and Cs. One kind of the halide powder may be used alone and two or more kinds thereof may be used in combination. It is preferable that the halide powder have a purity of 3 N or more. As the halide powder, a powder of which an average particle size is 15 μm or more is used. It is preferable that the average particle size of the halide powder be 50 μm to 300 μm. When the average particle size becomes too small, there are concerns that the halide powder may aggregate due to static electricity and it becomes difficult to crush the powder to a fine powder of which the maximum particle size is 15 μm or less. On the other hand, when the average particle size becomes too large, there is concern that the time for crushing to a fine powder of which the maximum particle size is 15 μm or less will become too long.

A moisture content of the halide powder is preferably 0.1 mass% or less, and particularly preferably 0.05 mass% or less. When the moisture content exceeds 0.1 mass%, there are concerns that the cohesiveness of the powder will increase remarkably and secondary particles will be easily formed due to reaggregation after the crushing operation. A lower limit of the moisture content is not particularly limited, but is preferably 0.001 mass%. For the measurement, the moisture content is calculated from the amount of mass reduction of the powder when heated up to 160°C, using a dry-dry moisture meter. That is, the moisture content is calculated by the following equation.

$$\text{Moisture content (mass\%)} = \text{amount of mass reduction (g) of halide powder by}$$

$$\text{heat treatment/mass (g) of halide powder before heat treatment} \times 100$$

In the halide powder, it is possible to remove adsorbed moisture by performing a drying treatment at 200°C under vacuum for 2 hours. It is conceivable to perform such a drying treatment in advance. However, in a case of using a powder obtained by the drying treatment, the amount of moisture in the environment outside the drying device becomes larger than that in the device. Therefore, the dried powder may adsorb moisture rapidly in some cases. As a result of rapid adsorption of the moisture, a so-called deliquescence phenomenon in which a saturated aqueous solution formed on the surface of the powder is diluted, and further dissolves the powder easily occurs. Accordingly, in an environment where the dew point is higher than -20°C, the operation of performing such a drying treatment may have an adverse effect. Therefore, in the embodiment, in a case of drying the halide powder, it is preferable to perform the drying in an environment where the dew point is -20°C or lower.

It is preferable that the Cu powder has a purity of 3 N or more. As the Cu powder, powder of which an average particle size is smaller than that of the halide powder is used. It is preferable that the average particle size of the Cu powder is 10 μm or more and less than 50 μm. When using the Cu powder of which the average particle size is smaller than that of the halide powder, it is possible to crush and mix both of the Cu powder and the halide powder in a state where the Cu powder adheres to the surface of the halide powder. Therefore, the reaggregation of the crushed halide powder is suppressed. Further, electric charges of the halide powder charged by static electricity can be leaked to conductive Cu powder, and there is also an effect of suppressing reaggregation of the halide powder due to the static electricity.

In addition, as the Cu powder, a powder of which a specific surface area is 0.15 $m^2/g$ or more is used. It is preferable that the specific surface area of the Cu powder be in a range of 0.15 $m^2/g$ to 1.0 $m^2/g$. When the specific surface area of the Cu powder becomes too small, there are concerns that it will become difficult for the Cu powder to adhere to the surface of the halide powder, the probability of contact between the halide powders will increase, and reaggregation of the halide powder will be likely to occur. On the other hand, when the specific surface area of the Cu powder becomes too large, the Cu powder reaggregates to form coarse particles. Therefore, there is a concern that it will become difficult for the Cu powder to adhere to the surface of the halide powder.

It is preferable that the mixing ratio between the halide powder and the Cu powder be set such that the content of the halide powder is 10 mass% or less. When the mixing ratio of the halide powder becomes too large, there are concerns that the crushed halide powder will be likely to reaggregate and the maximum particle size of the halide powder in the Cu-halide mixed powder will increase. It is preferable that the content of the halide powder in the Cu-halide mixed powder be 1 mass% or more.

For crushing and mixing the halide powder and the Cu powder, for example, a crushing mixer such as a ball mill device using a crushing medium (ball) and a Henschel mixer using a shearing force can be used. In a case of using the ball mill device, for example, it is preferable that a total of 3 to 5 kg of the weighed halide powder and the Cu powder and 5 to 10 kg of zirconia balls each having a diameter of 5 mm be put into a ball mill container having capacity of 10 L, the container be filled with Ar gas or N2 gas, and then an operation be performed for 20 to 40 hours at a rotation speed of 85 to 100 rpm.

The fact that the maximum particle size of the halide powder in the obtained Cu-halide mixed powder is 15 $\mu$m or less can be confirmed, for example, as follows. First of all, the Cu-halide mixed powder is sintered to obtain the sintered body. An observation range of 50 mm $\times$ 50 mm randomly selected in a surface of the sintered body is observed using an SEM and the circumscribed circle equivalent diameter of a halide particle having the largest particle size is measured. A lower limit of the maximum particle size of the halide powder in the obtained Cu-halide mixed powder is not particularly limited, but is preferably 0.1 $\mu$m.

<Cu-Na Compound Mixed Powder Preparing Step S02>

In the Cu-Na compound mixed powder preparation step S02, a Na compound powder and the Cu powder are mixed to prepare a Cu-Na compound mixed powder. The maximum particle size of the Na compound powder in the Cu-Na compound mixed powder is preferably 15 $\mu$m or less.

The Na compound powder includes Na and at least one element selected from the group consisting of F, Cl, Br, I, S, and Se. One kind of the Na compound powder may be used alone and two or more kinds thereof may be used in combination. It is preferable that the Na compound powder have a purity of 3 N or more. The average particle size of the Na compound powder is preferably 15 $\mu$m or more, and particularly preferably in a range of 50 $\mu$m to 300 $\mu$m. When the average particle size becomes too small, there are concerns that the Na compound powder may aggregate due to static electricity and it becomes difficult to crush the powder to a fine powder of which the maximum particle size is 15 $\mu$m or less. On the other hand, when the average particle size becomes too large, there is a concern that the time for crushing the Na compound powder until the particle sizes become 15 $\mu$m or less will become too long.

As the Cu powder, the same powder as used in the Cu-halide mixed powder preparing step S01 can be used.

It is preferable that the mixing ratio between the Na compound powder and the Cu powder be set such that the content of the Na compound powder is 10 mass% or less. It is preferable that the content of the Na compound powder in the Cu-Na compound mixed powder be 1 mass% or more. An upper limit of the content of the Na compound powder is preferably 5 mass%, but is not limited thereto.

For crushing and mixing the Na compound powder and the Cu powder, for example, a crushing mixer such as a ball mill device or a Henschel mixer can be used. The crushing and mixing can be performed under the same conditions as in the Cu-halide mixed powder preparing step S1.

The maximum particle size of the Na compound powder in the obtained Cu-Na compound mixed powder is preferably 15 $\mu$m or less. A lower limit of the maximum particle size of the Na compound powder in the obtained Cu-Na compound mixed powder is not particularly limited, but is preferably 0.1 $\mu$m.

<Cu-Ga alloy powder preparing step S03>

In the Cu-Ga alloy powder preparing step S03, a Cu-Ga alloy powder is prepared by the following procedure.

First, a massive Cu raw material and a massive Ga raw material are weighed to obtain a predetermined composition and are put into a crucible formed of carbon, and this crucible is set in a gas atomization device. The raw materials are melted by being evacuated and being held under a temperature condition of 1000°C to 1200°C for 1 minute to 30 minutes, and then, while causing the molten alloy to drop through nozzles having a pore size of 1 mm to 3 mm, Ar gas is injected at a gas injection pressure of 1 MPa to 5 MPa to prepare a gas atomized powder. The obtained gas atomized powder is cooled and then classified through a sieve having a pore size of 90 to 500 $\mu$m. As a result, a Cu-Ga alloy powder having a predetermined particle size is obtained.

<Mixing Step S04>

Next, the Cu-halide mixed powder, the Cu-Na compound mixed powder, and the Cu-Ga alloy powder which are prepared as described above are weighed so as to have a predetermined composition, and mixed using a mixing device to obtain the raw material mixed powder. It is preferable to use a mixer having a crushing function, such as a ball mill device or a Henschel mixer. When a ball mill device is used as the mixing crusher, it is preferable that conditions be as follows. A ball mill container having a capacity of 10 L is filled with Ar gas or N2 gas until an oxygen concentration reaches 100 ppm or less, and then 5 to 10 kg of zirconia balls having a diameter $\varphi$ of 5 mm and a total of 3 to 5 kg of the raw material powder (the Cu-halide powder, the Cu-Na compound mixed powder, and Cu-Ga alloy powder) are put into the container, and an operation is performed at 85 to 100 rpm for 20 to 40 hours. The crushing mixer such as a V-type mixer or a rocking mixer that mainly acts for mixing is not preferable because there is a concern of aggregation of the halide powder.

<Filling Step S05>

Next, a predetermined die is filled with the raw material mixed powder obtained as described above.

<Sintering Step S06>

Next, the raw material mixed powder with which the die was filled is sintered in a vacuum, an inert gas atmosphere, or a reducing atmosphere. It is preferable that a sintering temperature in the sintering step S06 be set according to the lowest melting point Tm between a melting point of Cu-Ga alloy which is a parent phase of the sintered body and a melting point of halides of K, Rb, and Cs which are the additive elements. Specifically, it is preferable that the sintering temperature be in a range of (Tm-70)°C to (Tm-20)°C. In addition, it is preferable that the sintering be performed under pressing.
It is preferable that pressure of the pressing be in a range of 1 MPa to 60 MPa. As a sintering method, pressureless sintering, hot pressing, or hot isostatic pressing can be applied.

<Machining Step S07>

In the machining step S07, a sputtering target having a predetermined shape is machined by cutting or grinding the obtained sintered body.
Since the halide easily dissolves in water, it is preferable to apply a dry method without using a coolant in the machining step S07.
In the method of manufacturing the Cu-Ga sputtering target according to the embodiment, the above described Cu-halide mixed powder preparation step S01, the mixing step S04, and the filling step S05 are performed under a gas atmosphere having a dew point of -20°C or lower and higher than -50°C. The gas atmosphere having a dew point of -20°C or lower and higher than -50°C can be made, for example, using a glove box and introducing an inert gas such as Ar or N2 or a dry air gas having a dew point of - 20°C or lower and higher than -150°C in the glove box.
When the Cu-halide mixed powder preparing step S01, mixing step S04, and filling step S05 are performed under an atmosphere in which a large amount of moisture is present, the halide powder in the Cu-halide mixed powder absorbs moisture and may reaggregate. In addition, when the halide powder absorbs moisture, oxidation of the Cu powder and the Cu-Ga alloy powder occurs due to heat generation due to the moisture absorption reaction, and there is a concern that an oxygen concentration may increase. Here, a lower dew point in the glove box decreases the amount of moisture in the atmosphere and the moisture absorption of the halide powder. However, when the dew point becomes lower than -50°C, reaggregation of the halide powder becomes likely to occur due to static electricity. Therefore, in the method of manufacturing the Cu-Ga sputtering target according to the embodiment, each step of the Cu-halide mixed powder preparation step S01, the mixing step S04, and the filling step S05 is performed under a gas atmosphere having a dew point of -20°C or lower and higher than -50°C.
Here, the filling Step S05 may be performed in the air as long as it is performed for an extremely short time. The extremely short time referred to here is 3 minutes under an environment of a temperature of 25°C and a humidity of 40% (dew point of 10°C).

Through the above steps, the Cu-Ga sputtering target according to the embodiment is manufactured. The Cu-Ga sputtering target is used by being bonded to a backing plate made of Cu, SUS (stainless), or another metal (for example, Mo) using In as a solder.

According to the Cu-Ga sputtering target of the embodiment having the above-described configuration, the Cu-Ga sputtering target has a composition including Ga in a range of 5 at% to 60 at%, at least one additive element selected from the group consisting of K, Rb, and Cs in a range of 0.01 at% to 5 at%, and a balance including Cu and inevitable impurities. Therefore, a Cu-Ga film having a relatively large amount of K, Rb, and Cs which are alkali metals can be formed.

Then, in the Cu-Ga sputtering target according to the embodiment, K, Rb, and Cs which are the alkali metals are included as the halide particles 2 of which the maximum particle size is 15 $\mu$m or less, in a state in which they are dispersed in the Cu-Ga parent phase 1. Therefore, abnormal discharge during sputtering can be suppressed and a Cu-Ga film in which K, Rb, and Cs which are the alkali metals are uniformly dispersed can be stably formed.

Further, the oxygen concentration is 1000 mass ppm or less. Therefore, there is less of oxides having high electric resistance, the occurrence of nodules can be reduced, and the abnormal discharge during sputtering can be more reliably suppressed. A lower limit of the oxygen concentration is not particularly limited, but is preferably 10 mass ppm.

In addition, in the method of manufacturing the Cu-Ga sputtering target of the embodiment, in the Cu-halide mixed powder preparing step, a fine powder of which the average particle size is smaller than that of the halide powder and the specific surface area is 0.15 m$^2$/g or more is used as the Cu powder and the mixing ratio between the halide powder and the Cu powder is set such that the content of the halide powder is 10 mass% or less. Therefore, a Cu-halide mixed powder in which the halide powder crushed to a size of 15 $\mu$m or less is uniformly dispersed can be obtained. In addition, the Cu-halide mixed powder preparing step and the mixing step of mixing the Cu-halide mixed powder and the Cu-Ga alloy powder to obtain the raw material mixed powder are performed under the gas atmosphere having a dew point of -20°C or lower and higher than -50°C. Therefore, it is difficult for the halide powder to absorb moisture or for the halide powder that has absorbed moisture to aggregate, and oxygen contamination can be suppressed. Thus, according to the method of manufacturing the Cu-Ga sputtering target of the embodiment, the above-described Cu-Ga sputtering target according to the embodiment can be obtained.

Hereinbefore, description has been given of the embodiments of the present invention. However, the present invention is not limited thereto, and approximate modifications can be made in a range not departing from the technical spirit of the present invention.

For example, in the embodiment, the method of manufacturing the Cu-Ga sputtering target including the Na compound was described, but the Cu-Ga sputtering target of the present invention may not include the Na compound. In addition, in the embodiment, all of K, Rb, and Cs which are the additive elements were described as being present in a state of halide particles, but in the Cu-Ga sputtering target of the present invention, a part of the additive elements may present in a state other than the halide particles. It is preferable that at least 30% (at% relative to the total amount of the additive elements) of additive elements be present in the state of halide particles.

Further, in the method of manufacturing the Cu-Ga sputtering target of the embodiment, the Na compound powder was used in the mixing step S04 as the Cu-Na compound mixed powder prepared in the Cu-Na compound mixed powder preparing step S02. However, the present invention is not limited thereto, the Na compound powder may be used alone. Further, a commercially available Cu-Ga alloy powder may be used without performing the Cu-Ga alloy powder preparing step S03.

EXAMPLES

Hereinafter, the results of an evaluation test for evaluating the effects of the sputtering target according to the present invention and the method of manufacturing the sputtering target will be described.

In the present example, the average particle size of each of the halide powder including K, Rb, and Cs which are the additive elements, Na compound powder, and Cu powder was measured using a laser diffraction type particle size distribution measuring apparatus. The average particle size of each of the halide powder and the Na compound powder was measured by a dry method and the average particle size of the Cu powder was measured by a wet method.

The specific surface area of the Cu powder was measured using a fully automatic specific surface area (BET) measuring device (HM-model-1201, manufactured by Macsorb).

[Examples 1 to 15 and Comparative Examples 1 to 7]

<Preparation of Sputtering Target>

A Cu-K halide mixed powder, a Cu-Na compound mixed powder, and a Cu-Ga alloy powder were prepared as follows.

In the Cu-halide mixed powder preparing step S01, first, the K halide powder with a purity of 3 N (99.9 mass%) and the Cu powder with a purity of 3 N shown in Table 1 were prepared and weighed such that a charging amount as shown in Table 1 was obtained and the total weight was 3 kg.

Next, the total amount (3 kg) of the weighed K halide powder and the Cu powder and 10 kg of zirconia balls each having a diameter φ of 5 mm were put into a ball mill container having a capacity of 10 L, the container was filled with Ar gas, and then crushing and mixing were performed for 20 hours at a rotation speed of 85 rpm to prepare a Cu-K halide mixed powder. The maximum particle size of the K halide powder in the prepared Cu-K halide mixed powder was measured as follows. The results are shown in the column "Maximum particle size of K halide after mixing" in Table 1.

(Maximum Particle Size of K Halide in Cu-K Halide Mixed Powder)

The Cu-K halide mixed powder was sintered by being held at a temperature of 750°C for 120 minutes while pressing at 20 MPa to obtain a sintered body. A surface of the obtained sintered body was dry polished with #500 sandpaper. An observation range of 50 mm×50 mm randomly selected in the polished surface was observed using an SEM and the circumscribed circle equivalent diameter of the K halide particle having the largest particle size was measured.

In the Cu-Na compound mixed powder preparing step S02, first, the Na compound powder with a purity of 3 N and the Cu powder with a purity of 3 N shown in Table 2 were prepared and weighed such that a charging amount as shown in Table 2 was obtained and the total weight was 3 kg.

Next, the total amount (3 kg) of the weighed Na compound powder and the Cu powder and 10 kg of zirconia balls each having a diameter φ of 5 mm were put into a ball mill container having a capacity of 10 L, the container was filled with Ar gas, and then crushing and mixing were performed for 20 hours at a rotation speed of 85 rpm to prepare Cu-Na compound mixed powder.

In the Cu-Ga alloy powder preparing step S03, first, a massive Cu raw material with a purity of 4 N and a massive Ga raw material with a purity of 4 N were weighed to obtain a charging amount shown in Table 2 and were put into a crucible formed of carbon.

Next, the crucible formed of carbon was set in a gas atomization device. The raw materials were melted by being evacuated and being held at 1100°C for 5 minutes, and then, while causing the molten alloy to drop through nozzles having a pore size of 1.5 mm, Ar gas was injected at a gas injection pressure of 2.5 MPa to prepare a gas atomized powder. The obtained gas atomized powder was cooled and then classified through a sieve having a pore size of 125 μm. The Cu-Ga alloy powder having a predetermined particle size (average particle size: 20 μm) was obtained.

Next, the Cu-K halide mixed powder, the Cu-Na compound mixed powder, and the Cu-Ga alloy powder prepared as described above were weighed such that a charging amount as shown in Table 3 was obtained and the total weight was 3 kg.

Next, the total amount (3 kg) of the weighed Cu-K halide mixed powder, the Cu-Na compound mixed powder, and the Cu-Ga alloy powder and 10 kg of zirconia balls each having a diameter φ of 5 mm were put into a ball mill container having a capacity of 10 L, the container was filled with Ar gas, and then crushing and mixing were performed under crushing and mixing conditions of an operation time of 20 hours at 85 rpm to prepare a raw material mixed powder (mixing step S04).

Next, a die was filled with the obtained raw material mixed powder (filling step S05).

Next, the die filled with the raw material mixed powder was heated using a hot press under the conditions of a pressing pressure of 20 MPa and a heating temperature 60°C lower than the melting point of the Cu-Ga alloy in a case where the melting point of the Cu-Ga alloy which is the parent phase is lower than the melting point of the K halide and 20°C lower than the melting point of a K halide in a case where the melting point of the Cu-Ga alloy which is the parent phase is higher than the melting point of the K halide. As a result, the raw material mixed powder was sintered to obtain a sintered body (sintering step S06).

Next, the obtained sintered body was ground. As a result, a Cu-Ga sputtering target of which a sputtering surface size was 127 mm long, 279.4 mm wide, and 10 mm thick was prepared (machining step S07).

In Examples 1 to 15 and Comparative Examples 1 to 6, each step of the Cu-halide mixed powder preparation step S01, the mixing step S04, and the filling step S05 was performed under an air atmosphere having a dew point of -20°C or lower and higher than -50°C. In Comparative Example 7, the filling step S05 was performed under the air atmosphere having a dew point of 20°C over 1 hour.

In addition, in Examples 1, 2, 4 to 6, 9, 10, and 12 to 15 and Comparative Examples 1 to 3, 5 and 6, the powder having a moisture content of 0.1 mass% or less was used as the K halide powder. In Examples 3, 7, 8, and 11 and Comparative Example 4 and 7, the K halide powder was placed on a metal dish in advance under an air atmosphere having a dew point of -20°C or less and higher than -50°C and heated using a heater mounted on a lower portion of the plate until the temperature of the metal plate reached 150°C, and then held for 10 minutes and dried. The obtained powder having the moisture content of 0.05 mass% or less was used.

<Evaluation>

For the prepared Cu-Ga sputtering target, contents of metal components, maximum particle size of each of the K halide particles and the Na compound particles, an oxygen concentration, variation of the K content, and abnormal discharge during sputtering were evaluated as follows. Evaluation results are shown in Table 4.

(Contents of Metal Components)

The prepared Cu-Ga sputtering target was crushed and pretreated with an acid. Then, composition analysis of Ga, K, and Na was performed by high frequency inductively coupled plasma emission spectroscopy (ICP-AES). The Cu component was described as a balance excluding Ga, K, and Na.

(Maximum Particle Size of K Halide Particles and Na Compound Particles)

The sputtering surface of the prepared Cu-Ga sputtering target was dry polished with #500 sandpaper. An observation range of 50 mm×50 mm randomly selected in the polished surface was observed using an SEM and the circumscribed circle equivalent diameter of each of the K halide particle and Na compound particle having the largest particle size was measured. In addition, element mapping images of K and Na were measured using an energy dispersive X-ray spectrometer (EDS), and the K halide particles and the Na compound particles were specified using the element mapping images.

(Oxygen Concentration)

The oxygen concentration was measured by an infrared absorption method described in JIS Z 2613: 1992 "General Method of Determination of Oxygen in Metallic Materials".

(Variation of K Content)

The prepared Cu-Ga sputtering target was divided into three equal parts in a longitudinal direction and divided into five equal parts in a lateral direction in the sputtering surface to be divided into 15 blocks in total. Next, the obtained blocks were further divided into five equal parts in a thickness direction to obtain thin blocks. A total of 45 thin blocks of three portions of the top, bottom, and middle portions of the thin blocks divided into five equal parts were taken out as sample pieces. The total of 45 sample pieces that were taken out were pretreated with an acid and the content of K was measured by ICP-AES. An average value of measured K content was calculated, and a value obtained by subtracting the average value of the K content from the maximum value of the measured K content was obtained as an upper part of variation and a value obtained by subtracting the minimum value of the measured K content from the average value of the K content was obtained as a lower part of the variation. The obtained values are shown in Table 4.

(Abnormal Discharge during Sputtering)

The prepared Cu-Ga sputtering target was used to form a film by sputtering under the following conditions. The sputtering was performed under conditions of sputtering gas: Ar gas, flow rate: 50 sccm, pressure: 0.67 Pa, and input power: two kinds of power of 3 W/cm$^2$ (low output) and 7 W/cm$^2$ (high output) for 1 hour each, and the number of abnormal discharges was measured using an arc counting function of a DC power supply. In the present example, an RPG-50 (manufactured by MKS Instruments) was used as the power supply. In a case where sputtering could not be continued for 1 hour, it was set as "cannot continue".

[Table 1]

| | | Cu-K halide mixed powder | | | | | | Maximum particle size of K halide after mixing ($\mu$m) |
|---|---|---|---|---|---|---|---|---|
| | | K halide powder | | | Cu powder | | | |
| | | Kind of halide | Average particle size ($\mu$m) | Charging amount (mass%) | Average particle size ($\mu$m) | Specific surface area (m$^2$/g) | Charging amount (mass%) | |
| | 1 | KF | 436 | 6.5 | 31.9 | 0.29 | 93.5 | 11.2 |

(continued)

| | | Cu-K halide mixed powder | | | | | | Maximum particle size of K halide after mixing ($\mu$m) |
|---|---|---|---|---|---|---|---|---|
| | | K halide powder | | | Cu powder | | | |
| | | Kind of halide | Average particle size ($\mu$m) | Charging amount (mass%) | Average particle size ($\mu$m) | Specific surface area ($m^2$/g) | Charging amount (mass%) | |
| Example | 2 | KF | 337 | 3.5 | 20.2 | 0.45 | 96.5 | 4.5 |
| | 3 | KF | 157 | 2.5 | 12.2 | 0.67 | 97.5 | 2.3 |
| | 4 | KCl | 230 | 7.5 | 43.2 | 0.17 | 92.5 | 13 |
| | 5 | KCl | 124 | 9.5 | 31.9 | 0.29 | 90.5 | 14.8 |
| | 6 | KBr | 53 | 5 | 5.8 | 0.76 | 95 | 7.2 |
| | 7 | KBr | 345 | 3.5 | 12.2 | 0.67 | 96.5 | 4.3 |
| | 8 | KI | 235 | 3 | 31.9 | 0.29 | 97 | 3.5 |
| | 9 | KI | 109 | 6.5 | 20.2 | 0.45 | 93.5 | 10.9 |
| | 10 | KF | 201 | 4 | 43.2 | 0.17 | 96 | 5.5 |
| | 11 | KCl | 230 | 3 | 12.2 | 0.67 | 97 | 3 |
| | 12 | KBr | 52 | 3.5 | 31.9 | 0.29 | 96.5 | 4.1 |
| | 13 | KI | 120 | 3 | 20.2 | 0.45 | 97 | 3.2 |
| | 14 | KCl | 230 | 3 | 31.9 | 0.29 | 97 | 2.9 |
| | 15 | KF | 337 | 3.5 | 20.2 | 0.45 | 96.5 | 3.6 |
| Comparative Example | 1 | KF | 15.7 | 3.5 | 43.2 | 0.17 | 96.5 | 16.3 |
| | 2 | KCl | 23.3 | 6.5 | 31.9 | 0.29 | 93.5 | 21.2 |
| | 3 | KBr | 345 | 12 | 20.2 | 0.45 | 88 | 30.6 |
| | 4 | KI | 109 | 10.5 | 31.9 | 0.29 | 89.5 | 27.8 |
| | 5 | KF | 157 | 3.5 | 56.9 | 0.13 | 96.5 | 17.1 |
| | 6 | KCl | 124 | 9.5 | 78.3 | 0.07 | 90.5 | 26.3 |
| | 7 | KF | 337 | 3.5 | 20.2 | 0.45 | 96.5 | 3.7 |

[Table 2]

| | | Cu-Na compound mixed powder | | | | | Cu-Ga alloy powder | |
|---|---|---|---|---|---|---|---|---|
| | | Na compound powder | | | Cu powder | | Cu-Ga powder | |
| | | Kind of compound | Average particle size ($\mu$m) | Charging amount (mass%) | Average particle size ($\mu$m) | Charging amount (mass%) | Ga charging amount (mass%) | Cu charging amount (mass%) |
| | 1 | - | - | - | - | - | 60 | Balance |
| | 2 | - | - | - | - | - | 50 | Balance |
| | 3 | - | - | - | - | - | 60 | Balance |
| | 4 | - | - | - | - | - | 50 | Balance |
| | 5 | - | - | - | - | - | 55 | Balance |

(continued)

| | | Cu-Na compound mixed powder | | | | | Cu-Ga alloy powder | |
| | | Na compound powder | | | Cu powder | | Cu-Ga powder | |
| | | Kind of compound | Average particle size (μm) | Charging amount (mass%) | Average particle size (μm) | Charging amount (mass%) | Ga charging amount (mass%) | Cu charging amount (mass%) |
|---|---|---|---|---|---|---|---|---|
| Example | 6 | - | - | - | - | - | 40 | Balance |
| | 7 | - | - | - | - | - | 50 | Balance |
| | 8 | - | - | - | - | - | 60 | Balance |
| | 9 | - | - | - | - | - | 60 | Balance |
| | 10 | NaCl | 258 | 10 | 31.9 | 90 | 60 | Balance |
| | 11 | NaBr | 320 | 12 | 20.2 | 88 | 50 | Balance |
| | 12 | Na$_2$S | 221 | 8 | 43.2 | 92 | 50 | Balance |
| | 13 | NaI | 120 | 25 | 5.8 | 75 | 60 | Balance |
| | 14 | Na$_2$Se | 340 | 9 | 12.2 | 91 | 50 | Balance |
| | 15 | NaF | 332 | 8.5 | 31.9 | 91.5 | 60 | Balance |
| Comparative Example | 1 | - | - | - | - | - | 50 | Balance |
| | 2 | - | - | - | - | - | 60 | Balance |
| | 3 | - | - | - | - | - | 60 | Balance |
| | 4 | - | - | - | - | - | 55 | Balance |
| | 5 | - | - | - | - | - | 50 | Balance |
| | 6 | - | - | - | - | - | 55 | Balance |
| | 7 | - | - | - | - | - | 50 | Balance |

[Table 3]

| | | Composition of mixed powder | | |
| | | Cu-K halide mixed powder (mass%) | Cu-Na compound mixed powder (mass%) | Cu-Ga alloy powder (mass%) |
|---|---|---|---|---|
| Example | 1 | 62.4 | - | 37.6 |
| | 2 | 35 | - | 65 |
| | 3 | 37.4 | - | 62.6 |
| | 4 | 45.2 | - | 54.8 |
| | 5 | 62 | - | 38 |
| | 6 | 20 | - | 80 |
| | 7 | 10 | - | 90 |
| | 8 | 52 | - | 48 |
| | 9 | 65 | - | 35 |
| | 10 | 20 | 20 | 60 |
| | 11 | 25 | 10 | 65 |
| | 12 | 67 | 13 | 20 |

(continued)

| | | Composition of mixed powder | | |
|---|---|---|---|---|
| | | Cu-K halide mixed powder (mass%) | Cu-Na compound mixed powder (mass%) | Cu-Ga alloy powder (mass%) |
| | 13 | 10 | 65 | 25 |
| | 14 | 45 | 5 | 50 |
| | 15 | 37 | 3 | 60 |
| Comparative Example | 1 | 27 | - | 73 |
| | 2 | 50 | - | 50 |
| | 3 | 20 | - | 80 |
| | 4 | 60 | - | 40 |
| | 5 | 35 | - | 65 |
| | 6 | 62 | - | 38 |
| | 7 | 35 | - | 65 |

[Table 4]

| | | Content of metal components of target | | | | Maximum particle size of K halide particles (μm) | Maximum particle size of Na compound particles (μm) | Oxygen concentration (mass ppm) | Variation of K content | | Number of abnormal discharges | |
|---|---|---|---|---|---|---|---|---|---|---|---|---|
| | | Ga (at%) | K (at%) | Na (at%) | Cu (at%) | | | | Upper part (mass%) | Lower part (mass%) | During 3 W/cm² sputtering (time/hour) | During 7 W/cm² sputtering (time/hour) |
| Example | 1 | 20 | 4.3 | - | Balance | 6.7 | - | 890 | 0.05 | 0.04 | 0 | 0 |
| | 2 | 30 | 1.4 | - | Balance | 3.4 | - | 600 | 0.03 | 0.02 | 0 | 0 |
| | 3 | 35 | 1 | - | Balance | 2.5 | - | 550 | 0.02 | 0.04 | 0 | 0 |
| | 4 | 25 | 2.9 | - | Balance | 10.1 | - | 760 | 0.02 | 0.02 | 0 | 4 |
| | 5 | 18.6 | 4.9 | - | Balance | 13.7 | - | 930 | 0.01 | 0.03 | 1 | 12 |
| | 6 | 30 | 0.5 | - | Balance | 12.2 | - | 450 | 0.03 | 0.02 | 0 | 21 |
| | 7 | 42.7 | 0.2 | - | Balance | 2.3 | - | 370 | 0.01 | 0.02 | 0 | 0 |
| | 8 | 27 | 0.6 | - | Balance | 4.7 | - | 460 | 0.04 | 0.03 | 0 | 0 |
| | 9 | 19.7 | 1.7 | - | Balance | 6.5 | - | 640 | 0.02 | 0.02 | 0 | 0 |
| | 10 | 32.8 | 0.9 | 2.2 | Balance | 3.2 | 5.3 | 490 | 0.04 | 0.03 | 0 | 0 |
| | 11 | 30.2 | 0.7 | 0.8 | Balance | 2.8 | 7.8 | 510 | 0.02 | 0.01 | 0 | 0 |
| | 12 | 9 | 1.2 | 1.7 | Balance | 12.2 | 7.2 | 550 | 0.03 | 0.04 | 1 | 21 |
| | 13 | 14.2 | 0.1 | 7.2 | Balance | 7.5 | 12.8 | 300 | 0.03 | 0.02 | 2 | 25 |
| | 14 | 23 | 1.2 | 0.5 | Balance | 3.5 | 3.5 | 510 | 0.04 | 0.02 | 0 | 0 |
| | 15 | 33.2 | 1.4 | 0.4 | Balance | 3.4 | 6.5 | 550 | 0.03 | 0.03 | 0 | 0 |

14

(continued)

| | | Content of metal components of target | | | | Maximum particle size of K halide particles (μm) | Maximum particle size of Na compound particles (μm) | Oxygen concentration (mass ppm) | Variation of K content | | Number of abnormal discharges | |
| | | Ga (at%) | K (at%) | Na (at%) | Cu (at%) | | | | Upper part (mass%) | Lower part (mass%) | During 3 W/cm² sputtering (time/hour) | During 7 W/cm² sputtering (time/hour) |
|---|---|---|---|---|---|---|---|---|---|---|---|---|
| | 1 | 34 | 1.1 | - | Balance | 15.5 | - | 480 | 0.02 | 0.03 | 21 | 199 |
| | 2 | 27.4 | 2.8 | - | Balance | 21.6 | - | 690 | 0.04 | 0.04 | 63 | Cannot continue |
| | 3 | 45.6 | 1.3 | - | Balance | 23.4 | - | 630 | 0.05 | 0.04 | 73 | Cannot continue |
| Comparative Example | 4 | 20.8 | 2.5 | - | Balance | 30.4 | - | 660 | 0.03 | 0.05 | 132 | Cannot continue |
| | 5 | 30 | 1.4 | - | Balance | 16.2 | - | 550 | 0.04 | 0.04 | 24 | 213 |
| | 6 | 18.6 | 4.9 | - | Balance | 45.8 | - | 890 | 0.06 | 0.04 | Cannot continue | Cannot continue |
| | 7 | 30 | 1.4 | - | Balance | 56.3 | - | 1400 | 0.08 | 0.07 | Cannot continue | Cannot continue |

In the Cu-Ga sputtering target having a maximum particle size of K halide particles exceeding 15 $\mu$m prepared in Comparative Examples 1 to 7, the number of abnormal discharges was large and it was not possible to stably perform sputtering. In particular, in Comparative Examples 2 to 4, 6, and 7 in which the maximum particle size of K halide particles exceeded 20 $\mu$m, sputtering could not be continued during high output sputtering of 7 W/cm$^2$. Further, in Comparative Examples 6 and 7 in which the maximum particle size of K halide particles exceeded 40 $\mu$m, sputtering could not be continued even during low output sputtering of 3 W/cm$^2$.

In Comparative Examples 1 and 2, it is considered that since the average particle size of the Cu powder was larger than the average particle size of the K halide powder, and it is difficult for the Cu powder to adhere to the surface of the K halide powder, the crushed K halide powder reaggregated to be coarsened. In Comparative Examples 3 and 4, it is considered that since the charging amount of the K halide powder was more than 10 mass%, the crushed K halide powder reaggregated to be coarsened. In Comparative Examples 5 and 6, it is considered that since the specific surface area of the Cu powder was less than 0.15 m$^2$/g, it became difficult for the Cu powder to adhere to the surface of the K halide powder, and the probability of contact between K halide powders increased, the crushed K halide powder reaggregated to be coarsened. In Comparative Example 7, it is considered that since the filling step S05 was performed under the atmosphere of a dew point of 20°C, the crushed K halide powder absorbed moisture and the moisture absorbed K halide powder reaggregated to be coarsened.

In contrast, in Examples 1 to 15 in which the maximum particle size of the K halide particles was 15 $\mu$m or less, the number of abnormal discharges was small and sputtering could be performed stably. In particular, in Examples 1 to 3, 7 to 11, 14, and 15 in which the maximum particle size of the K halide particles and the Na compound particles was 10 $\mu$m or less, abnormal discharge did not occur.

[Examples 16 to 24 and Comparative Examples 8 to 15]

A Cu-Ga sputtering target was manufactured in the same manner as in Examples 1 to 15 and Comparative Examples 1 to 6, except that a Rb halide powder with a purity of 3 N and a Cs halide powder with a purity of 3 N were used instead of the K halide particles and the charging amounts of each raw material and the heating temperature of the sintering step S06 were changed.

The charging amount of each of the Rb halide powder, the Cs halide powder, and the Cu powder in the Cu-halide mixed powder preparing step S01 is shown in Table 5. In addition, the maximum particle size of the halide powder in the prepared Cu-halide mixed powder was measured in the same manner as described above. The results are shown in the column of "Maximum particle size of Rb halide/Cs halide after mixing" in Table 5.

The charging amounts of the Na compound powder and the Cu powder in the Cu-Na compound mixed powder preparing step S02 and the charging amounts of the Cu raw material and the Ga raw material in the Cu-Ga alloy powder preparing step S03 are shown in Table 6.

The charging amounts of the Cu-halide mixed powder, the Cu-Na compound mixed powder, and Cu-Ga alloy powder in the mixing step S04 are shown in Table 7.

The heating temperature in sintering step S06 is 60°C lower than the melting point of the Cu-Ga alloy in a case where the melting point of the Cu-Ga alloy which is the parent phase is lower than the melting point of the halides of Rb and Cs and is 20°C lower than the melting point of halides of Rb and Cs in a case where the melting point of the Cu-Ga alloy which is the parent phase is higher than the melting point of the halides of Rb and Cs.

In Examples 16 to 24 and Comparative Examples 8 to 13, and 15, each step of the Cu-halide mixed powder preparation step S01, the mixing step S04, and the filling step S05 was performed under an air atmosphere having a dew point of -20°C or lower and higher than -50°C. In Comparative Example 14, the filling step S05 was performed under the air atmosphere having a dew point of 20°C over 1 hour.

In addition, in Examples 16, 17, 19, 20, and 22 to 24 and Comparative Examples 8, 9, and 11 to 15, the powder having a moisture content of 0.1 mass% or less was used as the halide powder. In Examples 18 and 21 and Comparative Example 10, the halide powder was placed on a metal plate in advance under an air atmosphere having a dew point of -20°C or less and higher than -50°C and heated using a heater mounted on a lower portion of the plate until the temperature of the metal plate reached 150°C, and then held for 10 minutes and dried. The obtained powder having the moisture content of 0.05 mass% or less was used.

For the prepared Cu-Ga sputtering target, contents of metal components, maximum particle size of each of the halide particles and the Na compound particles, an oxygen concentration, variation of the contents of Rb and Cs, and abnormal discharge during sputtering were evaluated in the manner as described above. Evaluation results are shown in Table 8.

[Table 5]

| | | Cu-halide mixed powder | | | | | | Maximum particle size of Rb halide/Cs halide after mixing (μm) |
|---|---|---|---|---|---|---|---|---|
| | | Rb halide powder/Cs halide powder | | | Cu powder | | | |
| | | Kind of halide | Average particle size (μm) | Charging amount (mass%) | Average particle size (μm) | Specific surface area (m²/g) | Charging amount (mass%) | |
| Example | 16 | RbF | 264 | 7.5 | 31.9 | 0.29 | 92.5 | 14.5 |
| | 17 | RbCl | 323 | 5 | 20.2 | 0.45 | 95 | 11.2 |
| | 18 | RbBr | 185 | 8 | 12.2 | 0.67 | 92 | 9.5 |
| | 19 | RbI | 126 | 4 | 43.2 | 0.17 | 96 | 6.4 |
| | 20 | CsF | 98.3 | 7.5 | 31.9 | 0.29 | 92.5 | 4.3 |
| | 21 | CsCl | 254 | 9 | 5.8 | 0.76 | 91 | 14.9 |
| | 22 | CsBr | 316 | 5 | 12.2 | 0.67 | 95 | 13.7 |
| | 23 | CsI | 175 | 6 | 5.8 | 0.76 | 94 | 12.1 |
| | 24 | RbF | 264 | 5 | 12.2 | 0.67 | 90 | 12.6(RbF) |
| | | CsF | 98.3 | 5 | | | | 14.7(CsF) |
| Comparative example | 8 | RbF | 12.4 | 7.5 | 31.9 | 0.29 | 92.5 | 26.4 |
| | 9 | RbCl | 323 | 12 | 20.2 | 0.45 | 88 | 35.4 |
| | 10 | RbBr | 20.3 | 8 | 56.9 | 0.67 | 92 | 16.4 |
| | 11 | RbI | 126 | 12 | 43.2 | 0.17 | 88 | 42.5 |
| | 12 | CsF | 10.2 | 7.5 | 31.9 | 0.29 | 92.5 | 23.6 |
| | 13 | CsCl | 254 | 9 | 5.8 | 0.07 | 91 | 19.5 |
| | 14 | CsBr | 316 | 7 | 12.2 | 0.67 | 93 | 11.5 |
| | 15 | CsI | 175 | 6 | 12.2 | 0.10 | 94 | 21.3 |

[Table 6]

| | | Cu-Na compound mixed powder | | | | | Cu-Ga alloy powder | |
| | | Na compound powder | | | Cu powder | | Cu-Ga powder | |
| | | Kin d of compound | Average particle size (μm) | Charging amount (mass%) | Average particle size (μm) | Charging amount (mass%) | Ga charging amount (mass%) | Cu charging amount (mass%) |
|---|---|---|---|---|---|---|---|---|
| Example | 16 | - | - | - | - | - | 60 | Balance |
| | 17 | - | - | - | - | - | 50 | Balance |
| | 18 | - | - | - | - | - | 60 | Balance |
| | 19 | NaCl | 258 | 5 | 31.9 | 95 | 50 | Balance |
| | 20 | - | - | - | - | - | 55 | Balance |
| | 21 | - | - | - | - | - | 40 | Balance |
| | 22 | - | - | - | - | - | 50 | Balance |
| | 23 | - | - | - | - | - | 60 | Balance |
| | 24 | - | - | - | - | - | 60 | Balance |
| Comparative Example | 8 | - | - | - | - | - | 60 | Balance |
| | 9 | - | - | - | - | - | 50 | Balance |
| | 10 | - | - | - | - | - | 50 | Balance |
| | 11 | NaCl | 258 | 5 | 31.9 | 95 | 60 | Balance |
| | 12 | - | - | - | - | - | 50 | Balance |
| | 13 | - | - | - | - | - | 60 | Balance |
| | 14 | - | - | - | - | - | 50 | Balance |
| | 15 | - | - | - | - | - | 60 | Balance |

[Table 7]

| | | Composition of mixed powder | | |
| | | Cu-halide mixed powder (mass%) | Cu-Na compound mixed powder (mass%) | Cu-Ga alloy powder (mass%) |
|---|---|---|---|---|
| Example | 16 | 50 | - | 50 |
| | 17 | 40 | - | 60 |
| | 18 | 30 | - | 70 |
| | 19 | 20 | 30 | 50 |
| | 20 | 60 | - | 40 |
| | 21 | 20 | - | 80 |
| | 22 | 40 | - | 60 |
| | 23 | 10 | - | 90 |
| | 24 | 30 | - | 70 |

(continued)

| | | Composition of mixed powder | | |
|---|---|---|---|---|
| | | Cu-halide mixed powder (mass%) | Cu-Na compound mixed powder (mass%) | Cu-Ga alloy powder (mass%) |
| Comparative Example | 8 | 60 | - | 40 |
| | 9 | 70 | - | 30 |
| | 10 | 30 | - | 70 |
| | 11 | 25 | 25 | 50 |
| | 12 | 60 | - | 40 |
| | 13 | 45 | - | 55 |
| | 14 | 60 | - | 40 |
| | 15 | 30 | - | 70 |

[Table 8]

| | | Content of metal components of target | | | | | Maximum particle size of Rb halide particles /Cs halide particles (μm) | Maximum crystal grain size of Na compound crystal grain (μm) | Oxygen concentration (mass ppm) | Variation of Rb content | | Variation of Cs content | | Number of abnormal discharges | |
|---|---|---|---|---|---|---|---|---|---|---|---|---|---|---|---|
| | | Ga (at%) | Rb (at%) | Cs (at%) | Na (at%) | Cu (at%) | | | | Upper part (mass%) | Lower part (mass%) | Upper part (mass%) | Lower part (mass%) | During 3 W/cm$^2$ sputtering (time/hour) | During 7 W/cm$^2$ sputtering (time/hour) |
| Example | 16 | 27.9 | 2.3 | - | - | Balance | 7.3 | - | 780 | 0.02 | 0.01 | - | - | 0 | 0 |
| | 17 | 28.1 | 1.1 | - | - | Balance | 7.5 | - | 550 | 0.02 | 0.03 | - | - | 1 | 3 |
| | 18 | 40.0 | 1.0 | - | - | Balance | 4.3 | - | 600 | 0.01 | 0.02 | - | - | 0 | 1 |
| | 19 | 22.7 | 0.2 | - | 2.6 | Balance | 3.2 | 7.4 | 420 | 0.01 | 0.02 | - | - | 0 | 0 |
| | 20 | 20.6 | - | 1.9 | - | Balance | 2.8 | - | 560 | - | - | 0.01 | 0.02 | 0 | 0 |
| | 21 | 30.2 | - | 0.7 | - | Balance | 3.1 | - | 470 | - | - | 0.02 | 0.02 | 0 | 1 |
| | 22 | 28.3 | - | 0.6 | - | Balance | 11.5 | - | 450 | - | - | 0.03 | 0.04 | 1 | 5 |
| | 23 | 51.9 | - | 0.2 | - | Balance | 9.6 | - | 400 | - | - | 0.04 | 0.03 | 0 | 3 |
| | 24 | 39.7 | 0.9 | 0.7 | - | Balance / Balance | 7.8(RbF) / 8.8(CsF) | - | 440 | 0.03 | 0.02 | 0.03 | 0.03 | 2 | 7 |
| Comparative Example | 8 | 22.1 | 2.8 | - | - | Balance | 15.7 | - | 650 | 0.04 | 0.03 | - | - | 27 | 174 |
| | 9 | 13.8 | 4.5 | - | - | Balance | 22.7 | - | 870 | 0.05 | 0.06 | - | - | 99 | Cannot continue |
| | 10 | 33.1 | 1.0 | - | - | Balance | 17.4 | - | 390 | 0.05 | 0.05 | - | - | 45 | 276 |
| | 11 | 27.8 | 0.9 | - | 2.2 | Balance | 29.4 | 5.3 | 670 | 0.07 | 0.06 | - | - | 298 | Cannot continue |
| | 12 | 18.7 | - | 1.9 | - | Balance | 19.8 | - | 660 | - | - | 0.06 | 0.05 | 74 | 432 |
| | 13 | 31.3 | - | 1.6 | - | Balance | 23.1 | - | 560 | - | - | 0.05 | 0.06 | 117 | Cannot continue |
| | 14 | 18.9 | - | 1.3 | - | Balance | 63.9 | - | 2300 | - | - | 0.09 | 0.08 | Cannot continue | Cannot continue |
| | 15 | 40.1 | - | 0.5 | - | Balance | 18.6 | - | 410 | - | - | 0.05 | 0.04 | 69 | 385 |

In the Cu-Ga sputtering target having a maximum particle size of halide particles exceeding 15 $\mu$m prepared in Comparative Examples 8 to 15, the number of abnormal discharges was large and it was not possible to stably perform sputtering. In particular, in Comparative Examples 9, 11, 13, and 14 in which the maximum particle size of the halide particles exceeded 20 $\mu$m, sputtering could not be continued during high output sputtering of 7 W/cm$^2$. Further, in Comparative Example 14 in which the maximum particle size of the halide particles exceeded 40 $\mu$m, sputtering could not be continued even during low output sputtering of 3 W/cm$^2$.

In Comparative Examples 8, 10, and 12, it is considered that since the average particle size of the Cu powder was larger than the average particle size of the halide powders of Rb and Cs and the Cu powder was less likely to adhere to the surface of halide powders of Rb and Cs, the crushed halide powders of Rb and Cs reaggregated to be coarsened. In Comparative Examples 9 and 11, it is considered that since the charging amount of the halide powders of Rb and Cs was larger than 10 mass%, the crushed halide powders of Rb and Cs reaggregated to be coarsened. In Comparative Examples 13 and 15, it is considered that since the specific surface area of the Cu powder was less than 0.15 m$^2$/g, it became difficult for the Cu powder to adhere to the surface of the halide powders of Rb and Cs, and the probability of contact between halide powders increased, the crushed halide powders of Rb and Cs reaggregated to be coarsened. In Comparative Example 14, it is considered that since the filling step S05 was performed under the atmosphere having a dew point of 20°C, the crushed halide powders of Rb and Cs absorbed moisture and the moisture absorbed halide powders of Rb and Cs reaggregated to be coarsened.

In contrast, in Examples 16 to 24 in which the maximum particle size of the halide particles of Rb and Cs was 15 $\mu$m or less, the number of abnormal discharges was small and sputtering could be stably performed.

Industrial Applicability

According to a Cu-Ga sputtering target according to the present invention and a Cu-Ga sputtering target manufactured by a method of manufacturing a Cu-Ga sputtering target according to the present invention, it is possible to stably form a Cu-Ga film that includes a relatively large amount of halides of K, Rb, and Cs, which are alkali metal compounds, and has a composition in which K, Rb, and Cs are uniformly dispersed.

Reference Signs List

1   Cu-Ga parent phase
2   Halide particles

**Claims**

1. A Cu-Ga sputtering target comprising: as a composition of metal components,
   Ga in a range of 5 at% to 60 at%;
   at least one additive element selected from the group consisting of K, Rb, and Cs in a range of 0.01 at% to 5 at%; and
   a balance including Cu and inevitable impurities,
   wherein all or a part of the additive element is present in a state of halide particles including at least one halogen selected from the group consisting of F, Cl, Br, and I,
   a maximum particle size of the halide particles is 15 $\mu$m or less, and
   an oxygen concentration is 1000 mass ppm or less.

2. The Cu-Ga sputtering target according to claim 1,
   wherein variation of a content of the additive element is 0.05 mass% or less.

3. The Cu-Ga sputtering target according to claim 1 or 2, further comprising:

   Na in a range of 0.01 at% to 10 at%,
   wherein the Na is present in a state of Na compound particles including at least one element selected from the group consisting of F, Cl, Br, I, S, and Se.

4. A method of manufacturing the Cu-Ga sputtering target according to claim 1, the method comprising:

   a Cu-halide mixed powder preparing step of crushing and mixing a halide powder including at least one halogen selected from the group consisting of F, Cl, Br, and 1 and at least one additive element selected from the group consisting of K, Rb, and Cs and having an average particle size of 15 $\mu$m or more and a Cu powder having an average particle size smaller than that of the halide powder and a specific surface area of 0.15 m$^2$/g or more at a mixing ratio at which a content of the halide powder is 10 mass% or less to prepare a Cu-halide mixed powder in which a maximum particle size of the halide powder is 15 $\mu$m or less;

a mixing step of mixing the Cu-halide mixed powder and a Cu-Ga alloy powder to obtain a raw material mixed powder;

a filling step of filling a die with the raw material mixed powder; and

a sintering step of sintering the raw material mixed powder with which the die was filled to obtain a sintered body, wherein the Cu-halide mixed powder preparing step and the mixing step are performed under a gas atmosphere having a dew point of -20°C or lower and higher than -50°C.

FIG. 1

5.0 μm

FIG. 2

```
┌──────────S01        ┌──────────S02        ┌──────────S03
│ Cu-HALIDE MIXED     │ Cu-Na COMPOUND MIXED │ Cu-Ga ALLOY POWDER
│ POWDER PREPARING STEP│ POWDER PREPARING STEP│ PREPARING STEP
└─────────┬───────────┘└─────────┬───────────┘└─────────┬──────
          │                       │                       │
          ▼                       ▼                       ▼
┌──────────────────┐   ┌──────────────────┐   ┌──────────────────┐
│   Cu-HALIDE      │   │  Cu-Na COMPOUND  │   │     Cu-Ga        │
│  MIXED POWDER    │   │  MIXED POWDER    │   │  ALLOY POWDER    │
└─────────┬────────┘   └─────────┬────────┘   └─────────┬────────┘
          │                       │                       │
          └───────────┐           │           ┌───────────┘
                      ▼   ▼   ▼
                 ┌──────────────────┐ ─S04
                 │   MIXING STEP    │
                 └─────────┬────────┘
                           ▼
                 ┌──────────────────┐
                 │  RAW MATERIAL    │
                 │  MIXED POWDER    │
                 └─────────┬────────┘
                           ▼   ─S05
                 ┌──────────────────┐
                 │   FILLING STEP   │
                 └─────────┬────────┘
                           ▼   ─S06
                 ┌──────────────────┐
                 │  SINTERING STEP  │
                 └─────────┬────────┘
                           ▼   ─S07
                 ┌──────────────────┐
                 │  MACHINING STEP  │
                 └─────────┬────────┘
                           ▼
            ╭──────────────────────────╮
            │ Cu-Ga SPUTTERING TARGET  │
            ╰──────────────────────────╯
```

## INTERNATIONAL SEARCH REPORT

| | International application No. |
|---|---|
| | PCT/JP2017/026073 |

A.  CLASSIFICATION OF SUBJECT MATTER
*C23C14/34*(2006.01)i, *B22F1/00*(2006.01)i, *C22C1/04*(2006.01)i, *C22C9/00*
(2006.01)i, *C22C28/00*(2006.01)i, *C22C30/02*(2006.01)i, *H01L31/0749*
(2012.01)i, *H01L31/18*(2006.01)i
According to International Patent Classification (IPC) or to both national classification and IPC

B.  FIELDS SEARCHED

Minimum documentation searched (classification system followed by classification symbols)
C23C14/34, B22F1/00, C22C1/04, C22C9/00, C22C28/00, C22C30/02, H01L31/0749,
H01L31/18

Documentation searched other than minimum documentation to the extent that such documents are included in the fields searched
Jitsuyo Shinan Koho         1922–1996   Jitsuyo Shinan Toroku Koho   1996–2017
Kokai Jitsuyo Shinan Koho   1971–2017   Toroku Jitsuyo Shinan Koho   1994–2017

Electronic data base consulted during the international search (name of data base and, where practicable, search terms used)
JSTPlus/JST7580/JSTChina(JDreamIII)

C.  DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2016-50363 A  (Mitsubishi Materials Corp.),<br>11 April 2016 (11.04.2016),<br>claims 1, 4, 6, 7<br>& WO 2016/031974 A1      & EP 3187619 A1<br>claims 1, 4, 6, 7 | 1<br>3<br>2,4 |
| X<br>A | JP 2016-28173 A  (Mitsubishi Materials Corp.),<br>25 February 2016 (25.02.2016),<br>claims 5 to 7<br>& US 2017/0178876 A1<br>claims 5 to 7<br>& WO 2016/006600 A1 | 1<br>2-4 |

| ☒ Further documents are listed in the continuation of Box C. | ☐ See patent family annex. |
|---|---|

| *    Special categories of cited documents: | "T"  later document published after the international filing date or priority date and not in conflict with the application but cited to understand the principle or theory underlying the invention |
|---|---|
| "A"  document defining the general state of the art which is not considered    to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search<br>21 August 2017 (21.08.17) | Date of mailing of the international search report<br>29 August 2017 (29.08.17) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2017/026073

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 4793504 B2  (Mitsubishi Materials Corp.),<br>12 October 2011 (12.10.2011),<br>claims 1, 2<br>& US 2012/0217157 A1<br>claims 1, 2<br>& WO 2011/055537 A1      & CN 102395702 A | 3<br>1,2,4 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016149404 A
- JP 2017050548 A
- WO 2011083647 A
- JP 4793504 B

**Non-patent literature cited in the description**

- General Method of Determination of Oxygen in Metallic Materials. *JIS Z 2613,* 1992